# FASCICULE DE BREVET EUROPEEN

(11) **EP 1 387 474 B1**
(45) Date de publication et mention de la délivrance du brevet: **02.01.2013**
(21) Numéro de dépôt: 03291854.2
(22) Date de dépôt: 25.07.2003
(51) Int. Cl.: H02M 1/096

(54) **Dispositif d'alimentation d'un élément de commande d'un composant électronique de puissance actif**
Versorgungsschaltung für das Schaltelement eines aktiven elektronischen Leistungselementes
Supply circuit for the control element of an active electronic power component

(30) Priorité: 30.07.2002 FR 0209645
(43) Date de publication de la demande: 04.02.2004
(73) Titulaire: INSTITUT NATIONAL POLYTECHNIQUE DE GRENOBLE, 38031 Grenoble Cédex 1 (FR)
(72) Inventeur: Crebier, Jean-Christophe, 38000 Grenoble (FR); Schaeffer, Christian, 38730 Le Pin (FR)
(74) Mandataire: Dossmann, Gérard

(56) Documents cités:
- EP-A- 0 351 898
- EP-A- 0 868 014
- DE-A- 10 045 093
- US-A- 5 347 166
- US-A- 5 455 758

## Description

L'invention relève du domaine de l'électronique de puissance et plus précisément de l'alimentation de la commande d'un composant actif de puissance.

Les composants actifs électroniques de puissance sont commandés par des commandes rapprochées qui doivent généralement être alimentées.

Les commandes rapprochées sont généralement connectées directement aux composants de puissance et possèdent un potentiel de référence flottant. Elles doivent être isolées pour des raisons fonctionnelles ou techniques, notamment de compatibilité électromagnétique.

Un système d'alimentation comprend en général un onduleur, un régulateur, une isolation galvanique, un redresseur, et un ou deux moyens de stockage d'énergie.

Les systèmes d'alimentation sont réalisés à partir de composants discrets ou dédiés. Toutefois, dans le cadre d'application à faible coût, l'alimentation génère une part importante du prix de revient.

L'invention vise à remédier aux inconvénients des systèmes d'alimentation classiques.

Le document US 5 455 758 décrit un dispositif selon le préambule de la revendication 1.

L'invention cherche à répondre au besoin d'alimentation à faible coût, simple et adapté à des applications variées, notamment en termes de tension aux bornes du composant de puissance.

Le dispositif d'alimentation, selon un aspect de l'invention, est destiné à un élément de commande d'un composant électronique de puissance actif.

Le dispositif comprend un moyen pour prélever de l'énergie aux bornes du composant de puissance sur une ligne d'alimentation dudit composant de puissance, un moyen de stockage de l'énergie prélevée et un moyen de fourniture de l'énergie stockée audit élément de commande.

Il n'est donc plus nécessaire de prévoir une isolation galvanique et le système d'alimentation peut être considérablement simplifié. On réalise ainsi l'auto-alimentation d'un composant de puissance.

De préférence, on prévoit un moyen de régulation de la tension du moyen de stockage d'énergie.

Avantageusement, le dispositif comprend au moins un composant actif.

Avantageusement, le dispositif d'alimentation est intégré avec le composant électronique de puissance. Ceci participe à la réduction du coût de l'alimentation. Dans le cas des fortes puissances, le dispositif d'alimentation est à base de composants multipuces associés à l'intérieur d'un module. Pour des puissances moyennes et faibles, on pourra envisager des solutions monolithiques.

Dans un contexte de forte intégration, l'invention propose de faire cohabiter plusieurs composants ayant des fonctions différentes mais avec certaines contraintes comparables. On bénéficie ainsi de procédés de fabrication collectifs du composant de puissance et de son alimentation.

Dans un mode de réalisation de l'invention, le dispositif comprend un transistor à effet de champ. Le transistor à effet de champ peut comprendre un drain relié à la ligne d'alimentation. Le transistor à effet de champ peut être monté en série avec une diode et un condensateur entre la ligne d'alimentation et une masse. L'élément de commande peut être relié en vue de son alimentation au point commun au condensateur et à la diode.

Dans un mode de réalisation de l'invention, le dispositif comprend un transistor JFET. La grille du transistor JFET peut être reliée à la masse. La masse peut être flottante et formée par une autre ligne d'alimentation. Le transistor JFET permet de réguler la tension du condensateur.

Dans un mode de réalisation de l'invention, le dispositif comprend un transistor MOS. Le dispositif peut comprendre un moyen de régulation de la tension de grille du transistor MOS. Le moyen de régulation peut comprendre une diode Zener ou une transil montée entre la grille du transistor MOS et la masse et une résistance montée entre la grille et le drain du transistor MOS. On peut ainsi réguler la tension aux bornes du condensateur de stockage d'énergie.

Dans un mode de réalisation de l'invention, le composant actif est réalisé à partir d'au moins une cellule du composant électronique de puissance équipé d'une pluralité de cellules disposées en parallèle. On peut prévoir d'utiliser entre 10 à 15% des cellules pour réaliser l'alimentation.

Une telle alimentation est applicable à la majeure partie des composants à grille isolée, du type MOSFET, IGBT, MBS ou autres. Ces composants ont de faibles exigences énergétiques en commande.

Le dispositif peut également s'appliquer à d'autres composants, tels que des transistors bipolaires, en fonction de leur consommation en énergie.

Le dispositif peut être utilisé avec une tension de puissance continue ou alternative, selon le domaine d'application du composant actif.

Le dispositif d'alimentation peut être incorporé dans tous les redresseurs et onduleurs actifs, dans les alimentations à découpage, dans l'entraînement des machines électriques, dans la gestion de l'énergie des réseaux de distribution, dans les produits grand public, tels que l'électroménager, le multimédia, la domotique, etc.

La présente invention sera mieux comprise et d'autres avantages apparaîtront à la lecture de la description détaillée de quelques modes de réalisation pris à titre d'exemples nullement limitatifs et illustrés par les dessins annexés, sur lesquels :
- la figure 1 est une vue schématique d'un composant électronique de puissance équipé d'une alimentation selon un aspect de l'invention ;
- la figure 2 est une vue plus détaillée de la figure 1 ;
- la figure 3 est un schéma électrique d'un mode de réalisation particulier de l'invention ;
- la figure 4 est un schéma électrique d'un autre mode de réalisation particulier de l'invention ; et
- la figure 5 est une vue schématique en perspective de l'alimentation dans un circuit intégré.

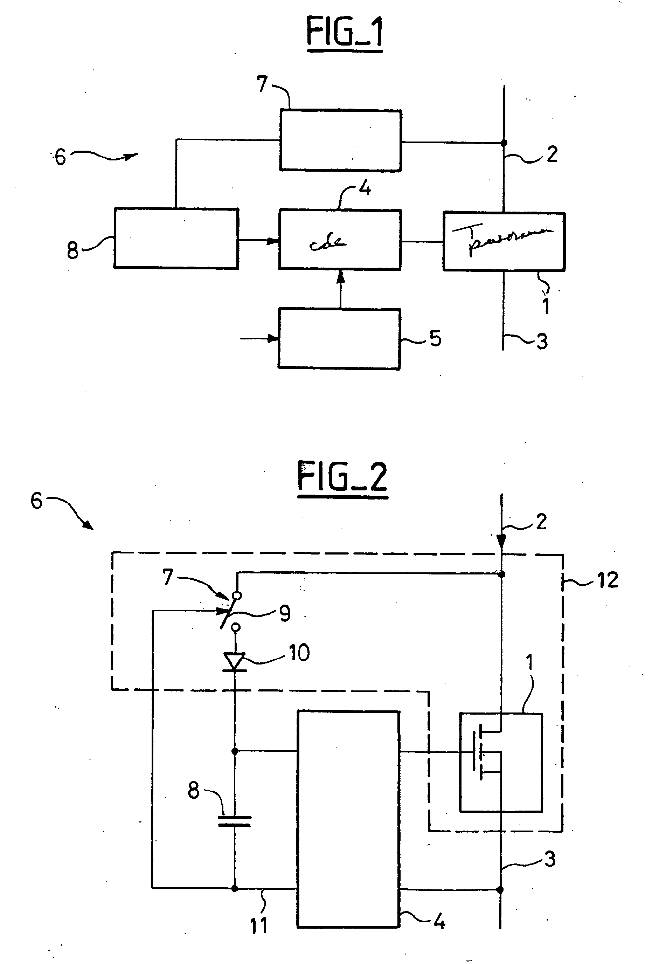

Comme on peut le voir sur la figure 1, un interrupteur de puissance 1, par exemple un transistor IGBT, est relié à deux lignes d'alimentation de puissance 2 et 3, et à un organe de commande rapproché 4. Les lignes 2 et 3 seront reliées aux bornes de puissance de l'interrupteur, par exemple à son collecteur et à son émetteur, tandis que l'organe de commande rapproché 4 sera relié à son entrée de commande, par exemple sa grille.

L'organe de commande rapproché 4 est relié à une interface isolée 5 qui assure la transmission d'instructions de commande en provenance d'autres éléments, non représentés. L'alimentation de l'organe de commande rapproché 4 est assurée par un dispositif d'alimentation 6, comprenant une alimentation proprement dite 7 et un élément de stockage 8. L'alimentation 7 est reliée à la ligne de puissance 2 et à l'élément de stockage 8 auquel elle est apte à fournir de l'énergie. L'élément de stockage 8 est relié à l'organe de commande rapproché 4.

On bénéficie ainsi d'une alimentation de l'élément de commande de l'interrupteur de puissance de structures simple, de fabrication économique et d'encombrement réduit.

Plus particulièrement, sur la figure 2, l'interrupteur de puissance 1 est un transistor MOS. L'interface 5 n'a pas été représentée. L'organe de commande rapproché 4 est également relié à la ligne de puissance 3 qui forme une masse flottante. L'alimentation 7 comprend un interrupteur électronique 9 monté en série avec une diode 10 et avec un élément de stockage 8 sous la forme d'un condensateur entre la ligne d'alimentation 2 et une borne 11 de l'organe de commande rapproché 4. Le point commun à la cathode de la diode 10 et à l'élément de stockage est également relié à l'organe de commande rapproché 4, tandis que l'anode de la diode 10 est reliée à l'interrupteur électronique 9. La borne de commande de l'interrupteur électronique 9 est reliée à la borne 11 de l'organe de commande rapproché 4. La borne 11 peut être reliée à la ligne de puissance 3.

Le transistor MOS 1, l'interrupteur de commande 9 et la diode 10 sont intégrés dans un même circuit intégré 12. En variante, on peut également prévoir l'intégrer le condensateur 8 dans le même circuit intégré. On utilise la différence de potentiel aux bornes du transistor MOS 1 lorsqu'il est ouvert pour fournir de l'énergie au dispositif d'alimentation 6. L'utilisation d'un interrupteur électronique 9, par exemple de type MOS ou encore JFET, au sein du même circuit intégré, permet de réguler aisément la tension du condensateur de stockage 8, qui constitue une réserve d'alimentation de l'organe de commande rapproché 4. Le prélèvement d'énergie est assuré par l'interrupteur électronique 9. Le stockage est assuré par le condensateur 8 et la diode 10. La fourniture d'énergie est assurée par la connexion de l'élément de commande 4 au point commun à la diode 10 et au condensateur 8.

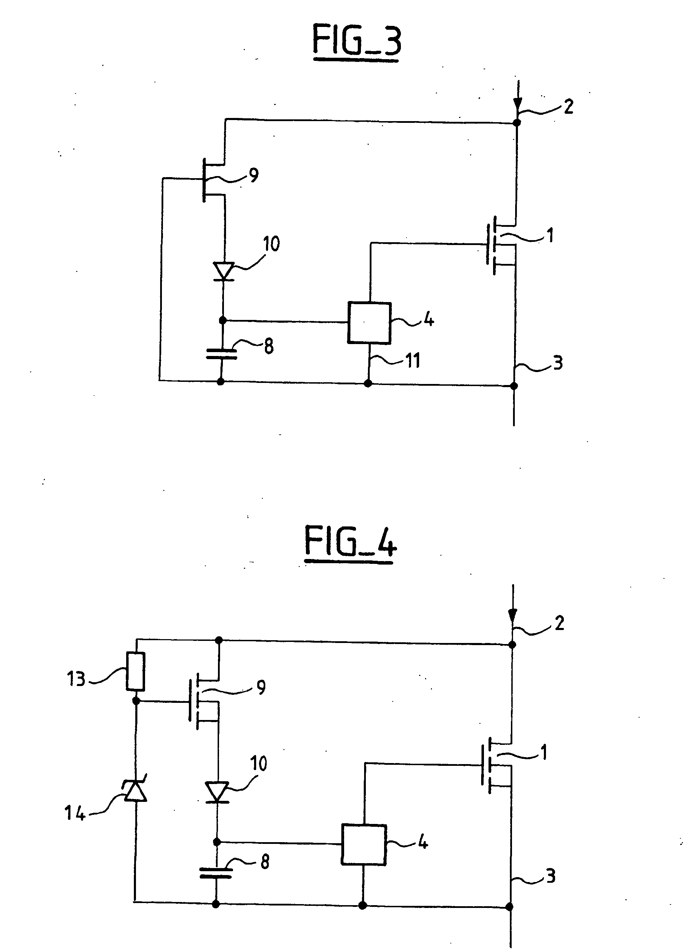

En figure 3, est illustrée une réalisation particulière, dans laquelle l'interrupteur électronique 9 est de type JFET haute tension et le transistor 1 est de type MOSFET de puissance. La borne 11 de l'organe de commande rapproché est également reliée à la ligne de puissance 3.

La diode 10 évite la décharge de l'élément de stockage 8 lorsque le transistor 1 est passant. Le transistor 1 étant bloqué, lorsque la tension aux bornes de l'élément de stockage 8 augmente, le courant passant par le transistor JFET 9 diminue. A l'inverse, lorsque ladite tension diminue, ledit courant augmente.

Ce dispositif d'alimentation fonctionne alors comme un régulateur linéaire en tirant profit de la caractéristique de commande d'un composant JFET, à savoir la commande en tension négative. La différence de potentiel aux bornes de l'élément de stockage 8 est directement appliquée en inverse entre la grille et la source du transistor JFET 9 pour piloter le niveau de courant traversant grâce à l'effet de transconductance du composant JFET.

L'alimentation et l'auto-régulation sont obtenues de manière efficace et très intégrée. Le transistor JFET de puissance est utilisé dans une zone où ces caractéristiques sont particulièrement intéressantes. Le courant absorbé par le dispositif d'alimentation et les niveaux de pertes restent relativement faibles.

Ce type de fonctionnement impose un positionnement sur les courbes caractéristiques courant/tension fixées par les caractéristiques du transistor JFET. En effet, le transistor JFET impose un couple courant/tension et donc une puissance de fonctionnement. La régulation de la tension est fonction de la puissance consommée.

Un tel dispositif d'alimentation est particulièrement efficace, facile à intégrer et les dynamiques de fonctionnement sont satisfaisantes. En outre, aucun organe de régulation n'est connecté au potentiel haut du transistor de puissance 1. La régulation en tension est dépendante de la tension d'alimentation, côté commande, et de la puissance consommée par la charge formée par l'organe de commande rapproché 4. Une adaptation peut être réalisée par un dispositif complémentaire en acceptant une très légère augmentation des pertes.

Sur la figure 4, est illustrée une autre réalisation particulière dans laquelle le comportement d'un transistor MOSFET classique est adapté de façon qu'il ressemble à celui d'un transistor JFET.

Le transistor 9 est donc de type MOSFET et sa grille est reliée au point commun entre une résistance 13 et une diode Zener 14 montées en série entre la ligne de puissance 2 et la ligne de puissance 3, l'anode de la diode Zener 14 étant reliée à la ligne de puissance 3. Les autres éléments sont semblables à ceux de la figure 3. Un tel montage est très efficace, également aisé à intégrer et peu sensible au choix de la tension d'alimentation côté puissance et de la puissance consommée par l'organe de commande rapproché 4. Les dynamiques de fonctionnement sont satisfaisantes. Bien entendu, d'autres montages peuvent être envisagés tout en restant dans le cadre de la présente invention. Une transil peut être prévue à la place de la diode Zener 14.

Dans les différentes réalisations décrites ci-dessus, le transistor 9 de l'alimentation et le transistor de puissance 1 sont soumis aux mêmes contraintes en tension, et cela au même instant.

Il est donc particulièrement avantageux de réaliser le transistor d'alimentation 9 dans le même circuit intégré que le transistor de puissance 1, et de leur faire partager le même procédé technologique en mettant à profit les étapes de fabrication du transistor de puissance 1 pour réaliser le transistor de puissance 9.

En outre, une telle intégration permet de disposer le transistor d'alimentation 9 au plus près du transistor de puissance 1, d'où une réduction de l'encombrement et des inductances parasites.

Dans le cas d'une intégration de type monolithique, le transistor d'alimentation 9 peut être rajouté au sein même du transistor de puissance 1 pour une application monopuce.

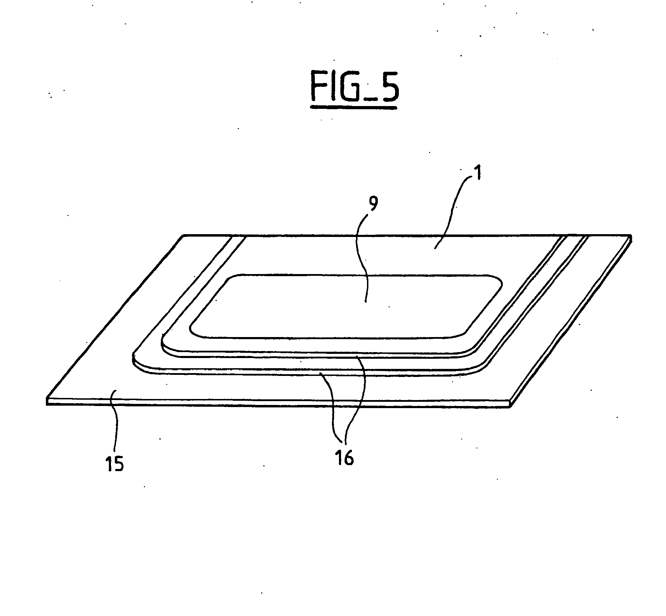

Sur la figure 5, une portion de circuit intégré comprend, sur la même puce 15, le transistor de puissance 1, qui peut être de type MOSFET, et le transistor d'alimentation 9, qui peut également être de type MOSFET, ou encore de type JFET associé à une diode. Des anneaux de garde 16 sont formés autour de la puce.

Une intégration hybride correspond à des applications multipuces, où l'une des puces sera dédiée à l'alimentation. La puce d'alimentation, soumise aux mêmes contraintes que les puces de puissance, peut faire partie du même module pour offrir, là encore, une intégration élevée.

Dans les différents modes de réalisation, lorsque l'interrupteur de puissance est ouvert, la différence de potentiel à ses bornes forme la tension d'alimentation de l'interrupteur de puissance et du dispositif d'alimentation sous la forme d'un régulateur linéaire simple comprenant un transistor JFET ou son équivalent, par exemple sous la forme d'un transistor MOSFET et d'une régulation, associé à un condensateur de stockage de l'énergie.

Le dispositif d'alimentation est applicable à l'ensemble des composants de puissance, en particulier aux composants à grille, tels que MOSFET, IGBT ou MBS, en raison de leur faible consommation en énergie.

Dans le cas des composants bidirectionnels en tension, notamment le MBS, destinés à des applications en courant alternatif, l'intégration monopuce s'avère être avantageuse car ainsi, seule l'alternance positive de la ligne de puissance est appliquée au dispositif d'alimentation, le rendant ainsi compatible entièrement avec lesdites applications en courant alternatif.

Bien entendu, le dimensionnement de l'élément de stockage d'énergie sera effectué en fonction de la fréquence de découpage minimale de l'interrupteur de puissance.

L'invention permet d'augmenter la fiabilité et la compacité de la commande d'un interrupteur de puissance, sans en affecter le coût. A cette fin, il est particulièrement avantageux de réaliser l'alimentation de façon intégrée avec le composant électronique de puissance actif.

L'invention propose ainsi un dispositif d'alimentation d'un élément de commande de composant électronique de puissance actif, comprenant un composant actif intégré avec le composant électronique de puissance, formant un moyen pour prélever de l'énergie aux bornes du composant de puissance sur une ligne d'alimentation de celui-ci, un moyen de stockage de l'énergie prélevée et un moyen de fourniture de l'énergie stockée audit élément de commande.

L'invention propose encore un circuit intégré comprenant un composant électronique de puissance actif et un dispositif d'alimentation d'un élément de commande dudit composant électronique de puissance, le dispositif d'alimentation comprenant un moyen pour prélever de l'énergie aux bornes du composant de puissance sur une ligne d'alimentation de celui-ci, un moyen de stockage de l'énergie prélevée et un moyen de fourniture de l'énergie stockée audit élément de commande.

## Revendications

1. Circuit intégré (15) comprenant an moins un composant électronique de puissance actif (1), un dispositif d'alimentation d'un élément de commande du composant électronique de puissance actif (1), ledit dispositif d'alimentation comprenant un moyen pour prélever de l'énergie sur une ligne d'alimentation dudit composant de puissance, un moyen de stockage de l'énergie prélevée, un moyen de fourniture de l'énergie stockée audit élément de commande, **caractérisé par le fait qu'**il comprend au moins un composant actif intégré avec le composant électronique de puissance.

2. Circuit selon la revendication 1, **caractérisé par** le fait qu_{'}il comprend un moyen de régulation de la tension du moyen de stockage d'énergie.

3. Circuit selon l'une quelconque des revendications précédentes, **caractérisé par le fait qu'**il comprend un transistor à effet de champ.

4. Circuit selon la revendication 3, **caractérisé par le fait que** le transistor à effet de champ comprend un drain relié à là ligne d'alimentation.

5. Circuit selon la revendication 3 ou 4, **caractérisé par le fait que** ledit transistor à effet de champ est monté en série avec une diode (10) et un condensateur (8) entre ladite ligne d'alimentation et une masse.

6. Circuit selon la revendication 5, **caractérisé par le fait que** ledit élément de commande (4) est relié en vue de son alimentation au point commun au condensateur (8) et à la diode (10).

7. Circuit selon l'une quelconque des revendications précédentes **caractérisé par le fait qu'**il comprend un transistor JFET.

8. Circuit selon la revendication 7, **caractérisé par le fait que** la grille du transistor JFET est reliée à la masse.

9. Circuit selon l'une quelconque des revendications 1 à 6, **caractérisé par le fait qu'**il comprend un transistor MOS.

10. Circuit selon la revendication 9, **caractérisé par le fait qu'**il comprend un moyen de régulation de la tension de grille dudit transistor MOS.

11. Circuit selon la revendication 10, **caractérisé par le fait que** ledit moyen de régulation comprend une diode Zener (14) ou une transil montée entre la grille du transistor MOS et la masse et une résistance (13) montée entre la grille et le drain du transistor MOS.

12. Circuit selon l'une quelconque des revendications précédentes, **caractérisé par le fait que** ledit composant actif est réalisé à partir d'au moins une cellule du composant électronique de puissance équipé d'une pluralité de cellules disposées en parallèle.

## Claims

1. Integrated circuit (15) comprising at least one active power electronic component (1), a power supply device for a control element of the active power electronic component (1), said power supply device comprising a means for tapping energy from a power supply line of said power component, a means for storing the tapped energy, a means for supplying the stored energy to said control element, **characterized in that** it comprises at least one active component integrated with the power electronic component.

2. Circuit according to Claim 1, **characterized in that** it comprises a means for regulating the voltage of the energy storage means.

3. Circuit according to any one of the preceding claims, **characterized in that** it comprises a field effect transistor.

4. Circuit according to Claim 3, **characterized in that** the field effect transistor comprises a drain linked to the power supply line.

5. Circuit according to Claim 3 or 4, **characterized in that** said field effect transistor is mounted in series with a diode (10) and a capacitor (8) between said power supply line and a ground.

6. Circuit according to Claim 5, **characterized in that** said control element (4) is linked for its power supply to the point common to the capacitor (8) and the diode (10).

7. Circuit according to any one of the preceding claims, **characterized in that** it comprises a JFET transistor.

8. Circuit according to Claim 7, **characterized in that** the gate of the JFET transistor is linked to the ground.

9. Circuit according to any one of Claims 1 to 6, **characterized in that** it comprises an MOS transistor.

10. Circuit according to Claim 9, **characterized in that** it comprises a means for regulating the gate voltage of said MOS transistor.

11. Circuit according to Claim 10, **characterized in that** said regulation means comprises a Zener diode (14) or a transil mounted between the gate of the MOS transistor and the ground and a resistor (13) mounted between the gate and the drain of the MOS transistor.

12. Circuit according to any one of the preceding claims, **characterized in that** said active component is produced from at least one cell of the power electronic component equipped with a plurality of cells arranged in parallel.

## Patentansprüche

1. Integrierte Schaltung (15), die mindestens ein aktives elektronisches Leistungsbauteil (1) und eine Versorgungsvorrichtung eines Steuerelements des aktiven elektronischen Leistungsbauteils (1) enthält, wobei die Versorgungsvorrichtung eine Einrichtung, um Energie von einer Versorgungsleitung des Leistungsbauteils abzugreifen, eine Einrichtung zum Speichern der abgegriffenen Energie, eine Einrichtung zum Liefern der gespeicherten Energie an die Steuereinrichtung enthält, **dadurch gekennzeichnet, dass** sie mindestens ein aktives Bauteil enthält, das in das elektronische Leistungsbauteil integriert ist.

2. Schaltung nach Anspruch 1, **dadurch gekennzeichnet, dass** sie eine Einrichtung zum Regeln der Spannung der Energiespeichereinrichtung enthält.

3. Schaltung nach einem der vorhergehenden Ansprüche, **dadurch gekennzeichnet, dass** sie einen Feldeffekttransistor enthält.

4. Schaltung nach Anspruch 3, **dadurch gekennzeichnet, dass** der Feldeffekttransistor einen Drain enthält, der mit der Versorgungsleitung verbunden ist.

5. Schaltung nach Anspruch 3 oder 4, **dadurch gekennzeichnet, dass** der Feldeffekttransistor mit einer Diode (10) und einem Kondensator (8) zwischen der Versorgungsleitung und Masse in Reihe geschaltet ist.

6. Schaltung nach Anspruch 5, **dadurch gekennzeichnet, dass** das Steuerelement (4) für seine Versorgung mit dem gemeinsamen Punkt des Kondensators (8) und der Diode (10) verbunden ist.

7. Schaltung nach einem der vorhergehenden Ansprüche, **dadurch gekennzeichnet, dass** sie einen JFET-Transistor enthält.

8. Schaltung nach Anspruch 7, **dadurch gekennzeichnet, dass** das Gate des JFET-Transistors mit Masse verbunden ist.

9. Schaltung nach einem der Ansprüche 1 bis 6, **dadurch gekennzeichnet, dass** sie einen MOS-Transistor enthält.

10. Schaltung nach Anspruch 9, **dadurch gekennzeichnet, dass** sie eine Einrichtung zur Regelung der Gate-Spannung des MOS-Transistors enthält.

11. Schaltung nach Anspruch 10, **dadurch gekennzeichnet, dass** die Regeleinrichtung eine Zener-Diode (14) oder eine Transil-Diode, die zwischen das Gate des MOS-Transistors und Masse geschaltet ist, und einen Widerstand (13) enthält, der zwischen das Gate und den Drain des MOS-Transistors geschaltet ist.

12. Schaltung nach einem der vorhergehenden Ansprüche, **dadurch gekennzeichnet, dass** das aktive Bauteil ausgehend von mindestens einer Zelle des elektronischen Leistungsbauteils hergestellt wird, das mit einer Vielzahl von parallel angeordneten Zellen ausgestattet ist.
